# EUROPEAN PATENT SPECIFICATION

(11) **EP 2 179 588 B1**
(45) Date of publication and mention of the grant of the patent: **16.11.2011**
(21) Application number: 08765913.2
(22) Date of filing: 27.05.2008
(51) Int. Cl.: G10L 19/08, G10L 19/02, H04N 7/24

(54) **ENCODING METHOD AND APPARATUS FOR EFFICIENTLY ENCODING SINUSOIDAL SIGNAL WHOSE MAGNITUDE IS LESS THAN MASKING VALUE ACCORDING TO PSYCHOACOUSTIC MODEL AND DECODING METHOD AND APPARATUS FOR DECODING ENCODED SINUSOIDAL SIGNAL**
KODIERUNGSVERFAHREN UND VORRICHTUNG ZUM EFFIZIENTEN KODIEREN EINES SINUSFÖRMIGEN SIGNALS, DESSEN BETRAG GEMÄSS EINEM PSYCHOAKUSTISCHEN MODELL KLEINER ALS EIN MASKIERUNGSWERT IST, UND DEKODIERUNGSVERFAHREN UND VORRICHTUNG ZUM DEKODIEREN EINES KODIERTEN SINUSFÖRMIGEN SIGNALS
PROCÉDÉ ET APPAREIL DE CODAGE POUR CODER DE FAÇON EFFICACE UN SIGNAL SINUSOÏDAL DONT L'INTENSITÉ EST INFÉRIEURE À LA VALEUR DE MASQUAGE SELON LE MODÈLE PSYCHOACOUSTIQUE ET PROCÉDÉ ET APPAREIL DE DÉCODAGE POUR DÉCODER UN SIGNAL SINUSOÏDAL CODÉ

(30) Priority: 16.08.2007 KR 20070082287
(43) Date of publication of application: 28.04.2010
(73) Proprietor: Samsung Electronics Co., Ltd., Gyeonggi-do 442-742 (KR)
(72) Inventor: LEE, Nam-Suk, Suwon-si Gyeonggi-do 443-706 (KR); LEE, Geon-Hyoung, Hwanseong-si Gyeonggi-do 445-320 (KR); LEE, Chul-Woo, Suwon-si Gyeonggi-do 443-374 (KR); MOON, Han-Gil, Yangcheon-gu Seoul 158-070 (KR)
(74) Representative: Davies, Robert Ean
(86) International application number: PCT/KR2008/002939
(87) International publication number: WO 2009/022789

(56) References cited:
- WO-A2-2006/030340
- US-A1- 2004 204 936
- US-A1- 2006 015 328
- "Text of 14496-3:2001:/FDAM 2, Parametric Coding" ITU STUDY GROUP 16 - VIDEO CODING EXPERTS GROUP -ISO/IEC MPEG & ITU-T VCEG(ISO/IEC JTC1/SC29/WG11 AND ITU-T SG16 Q6), XX, XX, no. N6130, 23 February 2004 (2004-02-23), XP030013089
- TAORI R ET AL: "Closed-loop tracking of sinusoids for speech and audio coding" IEEE WORKSHOP ON SPEECH CODING PROCEEDINGS. MODEL, CODERS ANDERROR CRITERIA, XX, XX, 20 June 1999 (1999-06-20), pages 1-3, XP002149588

## Description

### Technical Field

Methods and apparatuses consistent with the present invention generally relate to processing an audio signal, and more particularly, to encoding a sinusoidal signal whose magnitude is less than a masking value according to a psychoacoustic model, and decoding an encoded sinusoidal signal.

### Background Art

Parametric coding expresses an audio signal by a particular parameter. Parametric coding is used in the Moving Picture Experts Group (MPEG)-4 standard.

In Parametric coding, parameters for audio components in each domain are extracted by performing three types of analysis, i.e., transient analysis, sinusoidal analysis, and noise analysis. The extracted parameters are formatted into a bitstream for transmission to a decoder.

After sinusoidal analysis, a sinusoidal signal is tracked for adaptive differential pulse code modulation (ADPCM) coding or differential pulse code modulation (DPCM) coding with respect to the sinusoidal signal. Tracking is a process of searching for sinusoidal components continuing from each other from among sinusoidal components included in previous and next frames and setting correspondence relationship between the found sinusoidal components.

A sinusoidal component of a current frame, which can be tracked from sinusoidal components of a previous frame, is referred to as a continuation sinusoidal component. Since difference-coding can be performed on continuation sinusoidal components using sinusoidal components of the previous frame, which correspond to the continuation sinusoidal components, the continuation sinusoidal components can be efficiently coded. A continuation sinusoidal component, which does not continue to a sinusoidal component of a next frame and disappears, is referred to as a death sinusoidal component.

On the other hand, a sinusoidal component of the current frame, which cannot be tracked from sinusoidal components of the previous frame, is referred to as a birth sinusoidal component. Difference-coding using sinusoidal components of the previous frame cannot be performed on a birth sinusoidal component and absolute-coding can be performed on the birth sinusoidal component. Thus, the birth sinusoidal component requires a large number of bits for encoding.

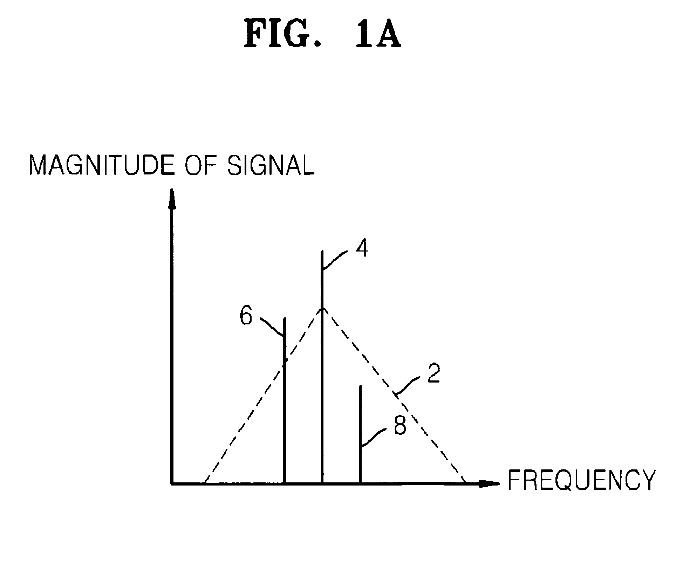

In encoding of audio data, attempts are made to reduce the number of bits of encoded data using a psychoacoustic model. FIG. 1A is a diagram for explaining a masking effect according to a psychoacoustic model.

As illustrated in FIG. 1A, when a particular audio signal 4 exists, sounds whose signal magnitudes are less than the magnitude of the audio signal 4 are not audible to human ears. A line expressing the minimum magnitude of a signal that is audile to human ears under existence of the particular audio signal 4 is called a masking curve 2 and a value of the masking curve 2 at a particular frequency is called a masking value.

Referring to FIG. 1A, the magnitude of a sinusoidal signal 6 is greater than a masking value and thus the sinusoidal signal 6 can be heard by human hears. Thus, the sinusoidal signal 6 must be encoded.

On the other hand, the magnitude of a sinusoidal signal 8 is less than the masking value and thus the sinusoidal signal 8 cannot be heard by human ears. For this reason, the sinusoidal signal 8 is not encoded in encoding using a psychoacoustic model. In other words, encoding using a psychoacoustic model processes a sinusoidal signal whose magnitude is less than a masking value as not existing.

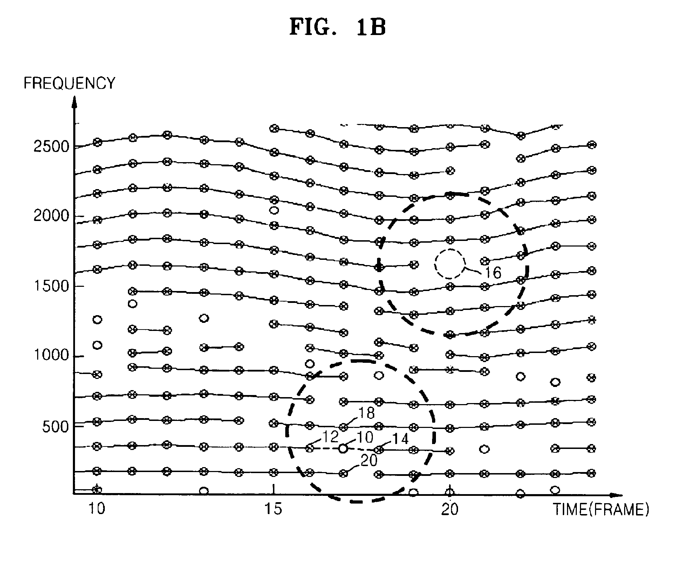

FIG. 1B is a diagram for explaining how a sinusoidal signal whose magnitude is less than a masking value according to a psychoacoustic model is treated in sinusoidal tracking.

Referring to FIG. 1B, a sinusoidal signal 10 has a magnitude that is less than a masking value according to a psychoacoustic model. The magnitude of the sinusoidal signal 10 is less than the magnitudes of sinusoidal signals 18 and 20 within the same frame as the sinusoidal signal 10.

When the psychoacoustic model is not applied, the sinusoidal signal 10 is connected with a sinusoidal signal 12 of a previous frame and with a sinusoidal signal 14 of a next frame. Thus, tracking of the sinusoidal signal 12, the sinusoidal signal 10, and the sinusoidal signal 14 is performed, and thus difference coding that is applicable to a continuation sinusoidal signal can be performed on the sinusoidal signal 14.

However, when the psychoacoustic model is applied, signals whose magnitudes are less than the masking value are treated as not existing like in an empty place 16 treated as not having any signal.

When the psychoacoustic model is applied, the sinusoidal signal 10 is treated as not existing and thus the sinusoidal signal 14 is treated as a birth sinusoidal signal, requiring a large number of bits for encoding.

If signals whose magnitudes are less than the masking value according to the psychoacoustic model are treated as not existing, a sinusoidal signal of a next frame has to be coded as a birth sinusoidal signal.

Moreover, even when such signals whose magnitudes are less than the masking value are coded, problems still occur.

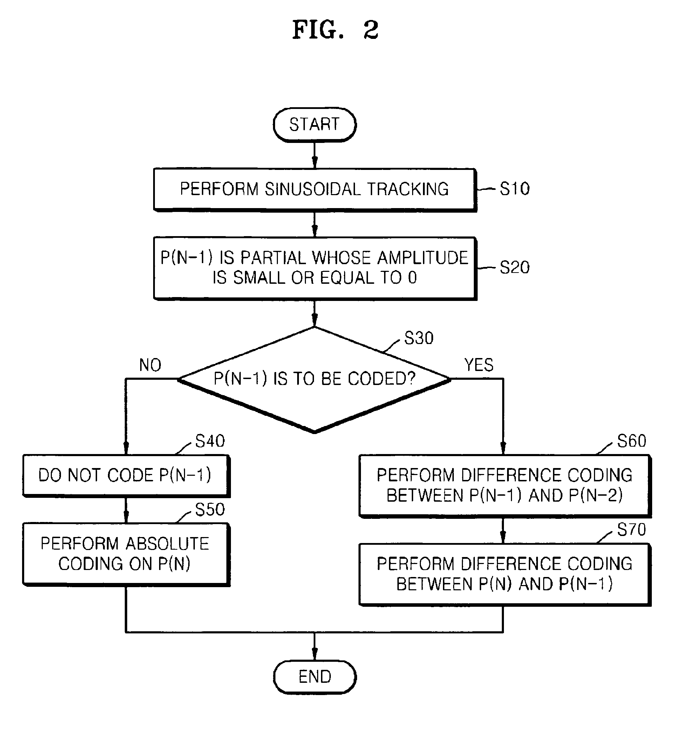

FIG. 2 is a flowchart illustrating a related art method for processing a signal whose magnitude is less than the masking value according to the psychoacoustic model.

First, sinusoidal tracking is performed in operation S10. It is assumed that P(n-2) and P(n-1) are connected and P(n-1) and P(n) are connected as a result of sinusoidal tracking.

In operation S20, P(n-1) is assumed to a signal having a magnitude that is less than the masking value according to the psychoacoustic model. Such a signal may have an amplitude of a small value or 0.

In operation S30, it is determined whether to code P(n-1) according to one of the previously mentioned two methods where the psychoacoustic model is applied or is not applied.

When the psychoacoustic model is applied and thus P(n-1) is treated as not existing, P(n-1) is not coded in operation S40 and P(n) that is a sinusoidal signal of a next frame is absolute-coded according to an encoding method for a birth sinusoidal signal in operation S50.

When it is determined to code P(n-1), difference coding between P(n-1) and P(n-2) is performed according to an encoding method for a continuation sinusoidal signal in operation S60 and difference coding between P(n) and P(n-1) is performed in operation S70.

As discussed above, when P(n-1) is not coded in operation S40, a large number of bits are required to code amplitude, frequency, and phase components because the encoding method for a birth sinusoidal signal is applied to P(n).

When P(n-1) is coded in operation S60, the number of bits used to code the frequency or amplitude component is small. However, since the amplitude of P(n-1) is small or equal to 0, a difference between the amplitude of P(n-1) and the amplitude of P(n-2) is very large. Also, the difference between the amplitude of P(n) and the amplitude of P(n-1) is very large. Thus, a large number of bits may be used to encode the difference or the difference may be in a range that cannot be expressed.

As such, in order to encode an audio signal including a sinusoidal signal whose magnitude is less than a masking value according to a psychoacoustic model using the related art method, more bits than in a case with coding of a general sinusoidal signal are required, degrading the efficiency of encoding.

### Disclosure of Invention

### Technical Solution

The present invention provides, in accordance with the appended claims, an encoding method and apparatus for encoding a sinusoidal signal and a decoding method and apparatus for decoding an encoded sinusoidal signal.

### Advantageous Effects

As described above, according to the exemplary embodiments of the present invention, by using the particular code indicating that the magnitude of the first sinusoidal signal is less than the masking value according to the psychoacoustic model to encode the first sinusoidal signal, difference coding for the third sinusoidal signal of the next frame, which is connected to the first sinusoidal signal, is performed using only the second sinusoidal signal of the previous frame, which is connected to the first sinusoidal signal or using both the first sinusoidal signal and the second sinusoidal signal according to a method to use the particular code, and the decoding apparatus decodes the third sinusoidal signal using a sinusoidal signal or sinusoidal signals selected according to the type of the particular code.

On the other hand, a related art method performs absolute coding or difference coding using the first sinusoidal signal for all components of the third sinusoidal signal in order to encode the third sinusoidal signal.

Therefore, when compared to the related art method, the number of bits required for encoding can be reduced and thus efficient encoding can be achieved.

### Description of Drawings

The above and other aspects of the present invention will become more apparent by describing in detail an exemplary embodiment thereof with reference to the attached drawings in which:

FIG. 1A is a diagram for explaining a masking effect according to a psychoacoustic model;

FIG. 1B is a diagram for explaining how a sinusoidal signal whose magnitude is less than a masking value according to the psychoacoustic model is treated in sinusoidal tracking;

FIG. 2 is a flowchart illustrating a related art method for processing a signal whose magnitude is less than the masking value according to the psychoacoustic model;

FIG. 3 is a flowchart illustrating an encoding method of encoding a sinusoidal signal according to an exemplary embodiment of the present invention;

FIG. 4 is a block diagram of an encoding apparatus for encoding a sinusoidal signal according to an exemplary embodiment of the present invention;

FIG. 5 illustrates a graph corresponding to encoding of a third sinusoidal signal using only a second sinusoidal signal;

FIG. 6 illustrates a graph corresponding to encoding of the third sinusoidal signal using both a first sinusoidal signal and the second sinusoidal signal; and

FIG. 7 is a block diagram of a decoding apparatus for decoding a sinusoidal signal according to an exemplary embodiment of the present invention.

### Best Mode

According to the present invention, there is provided a method of encoding a sinusoidal signal as set forth in independent claim 1, an apparatus for encoding a sinusoidal signal as set forth in independent claim 8, a method of decoding a sinusoidal signal as set forth in independent claim 10, and an apparatus for decoding a sinusoidal signal as set forth in independent claim 14.

### Mode for Invention

Hereinafter, an exemplary embodiment of the present invention will be described in detail with reference to the accompanying drawings. It should be noted that like reference numerals refer to like elements illustrated in one or more of the drawings. In the following description of the present invention, detailed description of known functions and configurations incorporated herein will be omitted for conciseness and clarity.

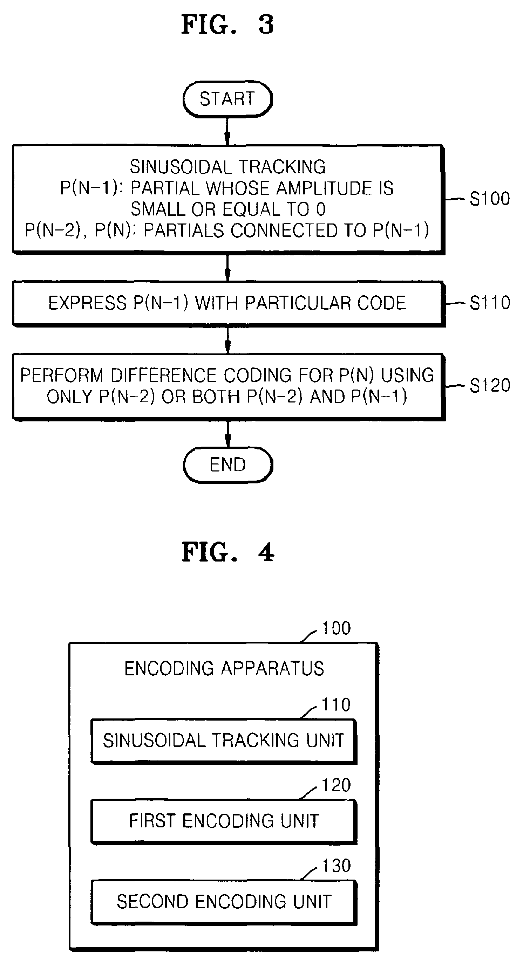

FIG. 3 is a flowchart illustrating an encoding method of encoding a sinusoidal signal according to an exemplary embodiment of the present invention, and FIG. 4 is a block diagram of an encoding apparatus 100 for encoding a sinusoidal signal according to an exemplary embodiment of the present invention.

Referring to FIG. 4, the encoding apparatus 100 may include a sinusoidal tracking unit 110, a first encoding unit 120, and a second encoding unit 130.

It is assumed that P(n-1) is a sinusoidal signal whose magnitude is less than a masking value according to a psychoacoustic model and P(n-2) and P(n-1) are connected and P(n-1) and P(n) are connected. In the following description, a sinusoidal signal whose magnitude is less than the masking value according to the psychoacoustic model is a first sinusoidal signal of sinusoidal signals of a current frame, one of sinusoidal signals of a previous frame, which is connected to the first sinusoidal signal, is a second sinusoidal signal, and one of sinusoidal signals of a next frame, which is connected to the first sinusoidal signal, is a third sinusoidal signal.

In operation S100, the sinusoidal tracking unit 110 performs sinusoidal tracking in order to determine the second sinusoidal signal and the third sinusoidal signal connected to the first sinusoidal signal.

In FIG. 3, the first sinusoidal signal is P(n-1), the second sinusoidal signal is P(n-2), and the third sinusoidal signal is P(n).

In operation S 110, the first encoding unit 120 encodes the first sinusoidal signal by expressing P(n-1), i.e., the first sinusoidal signal, with a particular code. The first encoding unit 120 uses the particular code indicating that the magnitude of the first sinusoidal signal is less than the masking value according to the psychoacoustic model.

In operation S120, the second encoding unit 130 encodes P(n), i.e., the third sinusoidal signal. The second encoding unit 130 may perform difference coding for the third sinusoidal signal P(n) using only the second sinusoidal signal P(n-2) or both the first sinusoidal signal P(n-1) and the second sinusoidal signal P(n-2) according to a method for the first encoding unit 120 to use the particular code.

The method to use the particular code may include the following examples. However, the method is not limited to the examples and may vary as long as the first encoding unit 120 uses the particular code indicating that the magnitude of the first sinusoidal signal is less than the masking value according to the psychoacoustic model.

<Method to use particular code>

1. Designating one of control flags as a flag indicating that the sinusoidal signal to be encoded has a magnitude that is less than the masking value according to the psychoacoustic model.

Control flags are used to encode a sinusoidal signal. By designating one of the control flags, it can be indicated that the sinusoidal signal to be encoded has a magnitude that is less than a masking value according to a psychoacoustic model. When such control flag is designated, it is not necessary to encode amplitude, frequency, and phase components of the first sinusoidal signal. For the third sinusoidal signal of the next frame, difference coding may be performed using the second sinusoidal signal. When compared to a related art method in which the first sinusoidal signal is treated as not existing, the number of bits can be reduced by performing difference coding for encoding of the third sinusoidal signal.

2. Encoding a particular value indicating that the magnitude of the first sinusoidal signal is less than the masking value according to the psychoacoustic model instead of encoding the amplitude component of the first sinusoidal signal.

For frequency and phase components of the first sinusoidal signal, difference coding is performed using frequency and phase components of the second sinusoidal signal of the previous frame. In this method, during encoding of the third sinusoidal signal, difference coding for an amplitude component of the third sinusoidal signal is performed using an amplitude component of the second sinusoidal signal, difference coding for a frequency component of the third sinusoidal signal is performed using a frequency component of the first sinusoidal signal, and difference coding for a phase component of the third sinusoidal signal is performed using the phase component of the first sinusoidal signal. By performing difference coding instead of absolute coding for encoding of the third sinusoidal signal, the number of bits required for the encoding can be reduced. Moreover, when compared to a related art method in which difference coding for the third sinusoidal signal is performed using only the first sinusoidal signal, related art problems that a large number of bits are required for encoding a difference or the difference is in a range that cannot be expressed can be solved by performing difference coding for the amplitude component of the third sinusoidal signal using the amplitude component of the second sinusoidal signal.

3. Encoding a particular value indicating that the magnitude of the first sinusoidal signal is less than the masking value according to the psychoacoustic model instead of encoding the frequency component (or phase component) of the first sinusoidal signal.

In this method, it is not necessary to encode amplitude and phase components (or frequency component) of the first sinusoidal signal. In this sense, this method is similar to the first method in which one of control flags is designated as a flag indicating that the sinusoidal signal to be encoded has a magnitude that is less than the masking value according to the psychoacoustic model.

For the third sinusoidal signal of the next frame, difference coding is performed using the second sinusoidal signal. When compared to the related art method that treats the first sinusoidal signal as not existing, this method can reduce the number of bits by performing difference coding for encoding of the third sinusoidal signal.

This method is similar to the first method and one of them may be selected to further reduce the number of bits according to embodiments. In other words, one of the first method using a particular code in the flag and this method encoding the particular value instead of the frequency or phase component of the first sinusoidal signal, which results in a smaller number of bits for encoding, can be selected.

In some embodiments, it may be difficult to additionally designate a particular flag. In this case, such a difficulty can be overcome using this method.

< Method to encode third sinusoidal signal>

A. When the first encoding unit 120 uses one of the first method and the third method, the second encoding unit 130 performs difference coding for the third sinusoidal signal using only the second sinusoidal signal.

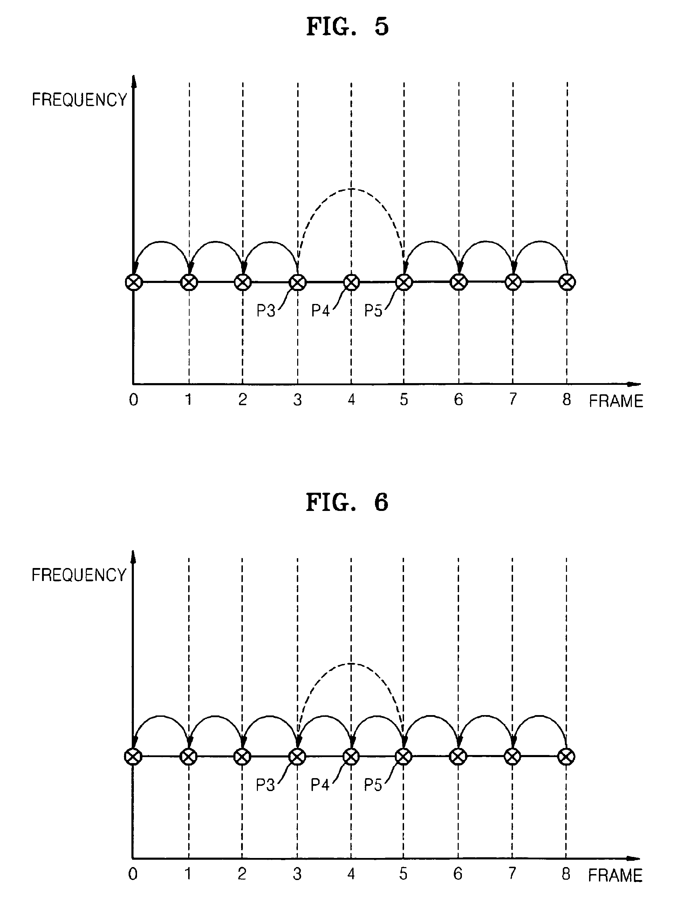

FIG. 5 illustrates a graph corresponding to encoding of the third sinusoidal signal using only the second sinusoidal signal. In FIG. 5, n is 5. Thus, the first sinusoidal signal is P4, the second sinusoidal signal is P3, and the third sinusoidal signal is P5.

To encode the first sinusoidal signal P4, a particular flag is designated according to the first method or a particular value is encoded instead of a frequency or phase component of the first sinusoidal signal P4 according to the third method.

To encode the third sinusoidal signal P5, difference coding is performed using only the second sinusoidal signal P3. In other words, for an amplitude component of the third sinusoidal signal P5, a difference between the amplitude component of the third sinusoidal signal P5 and an amplitude component of the second sinusoidal signal P3 is obtained and is then encoded, for a frequency component of the third sinusoidal signal P5, a difference between the frequency component of the third sinusoidal signal P5 and a frequency component of the second sinusoidal signal P3 is obtained and is then encoded, and for a phase component of the third sinusoidal signal P5, a difference between the phase component of the third sinusoidal signal P5 and a phase component of the second sinusoidal signal P3 is obtained and is then encoded.

B. When the first encoding unit 120 uses the second method, the second encoding unit 130 performs difference coding for the third sinusoidal signal using both the first sinusoidal signal and the second sinusoidal signal.

FIG. 6 illustrates a graph corresponding to encoding of the third sinusoidal signal using both the first sinusoidal signal and the second sinusoidal signal. In FIG. 6, n is 5. Thus, the first sinusoidal signal is P4, the second sinusoidal signal is P3, and the third sinusoidal signal is P5.

To encode the first sinusoidal signal P4, a particular value is encoded instead of an amplitude component of the first sinusoidal signal P4 according to the second method. In other words, for a frequency component of the first sinusoidal signal P4, a difference between the frequency component of the first sinusoidal signal P4 and a frequency component of the second sinusoidal signal P3 is obtained and is then encoded, and for a phase component of the first sinusoidal signal P4, a difference between the phase component of the first sinusoidal signal P4 and a phase component of the second sinusoidal signal P3 is obtained and is then encoded.

To encode the third sinusoidal signal P5, difference coding is performed using both the second sinusoidal signal P3 and the first sinusoidal signal P4. In other words, for an amplitude component of the third sinusoidal signal P5, a difference between the amplitude component of P5 and an amplitude component of the second sinusoidal signal P3 is obtained and is then encoded, for a frequency component of the third sinusoidal signal P5, a difference between the frequency component of the third sinusoidal signal P5 and a frequency component of the first sinusoidal signal P4 is obtained and is then encoded, and for a phase component of the third sinusoidal signal P5, a difference between the phase component of the third sinusoidal signal P5 and a phase component of the first sinusoidal signal P4 is obtained and is then encoded.

Although not illustrated in FIG. 4, the encoding apparatus 100 may further include a frequency conversion unit. The frequency conversion unit converts a frequency of the first sinusoidal signal and transmits the frequency-converted first sinusoidal signal to the first encoding unit 120.

When the frequency component of the second sinusoidal signal is fp and the frequency component of the third sinusoidal signal is fn, the frequency conversion unit converts the frequency of the first sinusoidal signal into an average frequency value of the frequencies of the second sinusoidal signal and the third sinusoidal signal, i.e., (fp+fn)/2.

The encoded sinusoidal signal is formatted into a bitstream for transmission to a decoding apparatus for decoding a sinusoidal signal from the encoding apparatus 100.

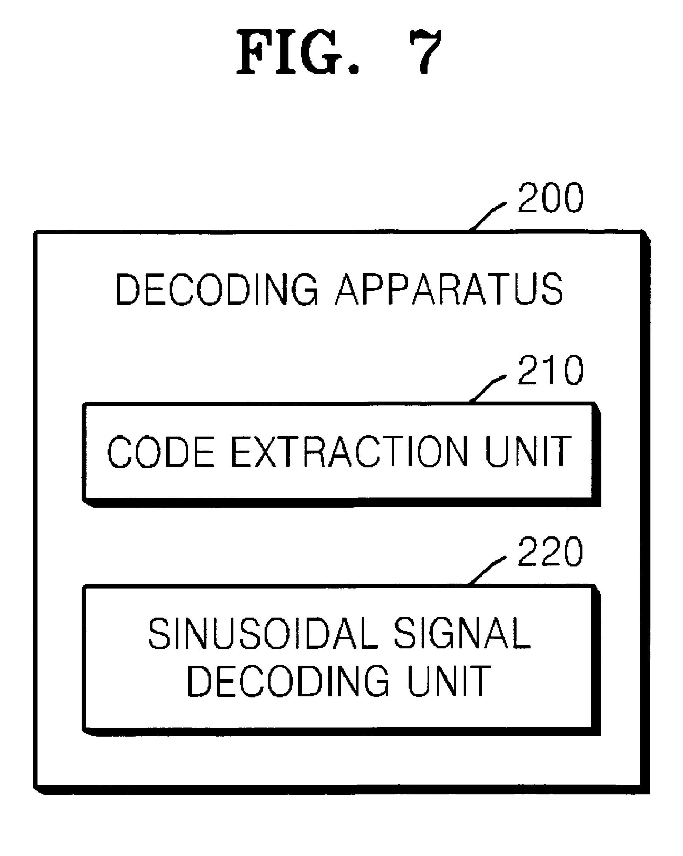

FIG. 7 is a block diagram of a decoding apparatus 200 for decoding a sinusoidal signal according to an exemplary embodiment of the present invention.

Referring to FIG. 7, the decoding apparatus 200 may include a code extraction unit 210 and a sinusoidal signal decoding unit 220.

The code extraction unit 210 extracts a particular code indicating that the magnitude of the first sinusoidal signal is less than the masking value according to the psychoacoustic model from the input bitstream.

The sinusoidal signal decoding unit 220 decodes the third sinusoidal signal using the second sinusoidal signal or using both the first sinusoidal signal and the second sinusoidal signal according to the type of the particular code as follows.

<Method to decode third sinusoidal signal>

A. When the encoding apparatus 100 uses the first method or the third method to use the particular code, the sinusoidal signal decoding unit 220 decodes the third sinusoidal signal using only the second sinusoidal signal.

In other words, the flag indicating that the magnitude of the first sinusoidal signal is less than the masking value according to the psychoacoustic model has been designated from among control flags used to encode the first sinusoidal signal (the first method) or the particular value indicating that the magnitude of the first sinusoidal signal is less than the masking value according to the psychoacoustic model has been encoded instead of the frequency (or phase) component of the first sinusoidal signal (the second method), and the flag or the encoded particular value has been included in the input bitstream.

Since the amplitude (frequency or phase) component of the first sinusoidal signal has not been encoded, an encoded difference for the amplitude (frequency or phase) component of the third sinusoidal signal is extracted from the input bitstream and is decoded. The decoded difference is added to an amplitude (frequency or phase) component of the second sinusoidal signal, thereby obtaining an amplitude (frequency or phase) component of the third sinusoidal signal.

B. When the encoding apparatus 100 uses the second method to use the particular code, the sinusoidal signal decoding unit 220 decodes the third sinusoidal signal using both the first sinusoidal signal and the second sinusoidal signal.

In other words, the particular value indicating that the magnitude of the first sinusoidal signal is less than the masking value according to the psychoacoustic model has been encoded instead of the amplitude component of the first sinusoidal signal and has been included in the input bitstream.

Since the amplitude component of the first sinusoidal signal is not encoded, an encoded difference for the amplitude component of the third sinusoidal signal is extracted from the input bitstream and is then decoded. The decoded difference is added to the amplitude component of the second sinusoidal signal, thereby obtaining the amplitude component of the third sinusoidal signal.

On the other hand, for the frequency and phase components of the first sinusoidal signal, the encoding apparatus 100 has performed difference coding using the frequency and phase components of the second sinusoidal signal. Thus, an encoded difference for the frequency (phase) component of the first sinusoidal signal is extracted from the input bitstream and is decoded. The decoded difference is added to the frequency (phase) component of the second sinusoidal signal, thereby obtaining the frequency (phase) component of the first sinusoidal signal.

An encoded difference for the frequency (phase) component of the third sinusoidal signal is extracted from the input bitstream and is decoded. The decoded difference is added to the frequency (phase) component of the first sinusoidal signal, thereby obtaining the frequency (phase) component of the third sinusoidal signal.

< Designation of components of first sinusoidal signal>

The first sinusoidal signal has a magnitude that is less than the masking value according to the psychoacoustic model. Since this signal is not audible to human ears, it may not be decoded by the decoding apparatus 200.

However, although not audible to human ears, the first sinusoidal signal may change the feeling of a sound due to its existence. Thus, a particular signal substituting the first sinusoidal signal may be designated.

First, a value that is less than the masking value according to the psychoacoustic model is designated as the amplitude component of the first sinusoidal signal.

The average frequency value (fp+fn)/2 of the frequency component fp of the second sinusoidal signal and the frequency component fn of the third sinusoidal signal is designated as the frequency component of the first sinusoidal signal.

By designating the amplitude and frequency components of the first sinusoidal signal, the first sinusoidal signal can be generated without affecting decoding of the third sinusoidal signal.

The present invention can also be embodied as code that can be read by a computer including any device having an information processing function on a computer-readable recording medium. The computer-readable recording medium is any data storage device that can store data which can be thereafter read by a computer system. Examples of the computer-readable recording medium include read-only memory (ROM), random-access memory (RAM), CD-ROMs, magnetic tapes, floppy disks, and optical data storage devices.

While the present invention has been particularly shown and described with reference to exemplary embodiments thereof, it will be understood by those of ordinary skill in the art that various changes in form and detail may be made therein without departing from the scope of the present invention as defined by the following claims.

## Claims

1. A method of encoding a sinusoidal signal, the method comprising: performing sinusoidal tracking for an audio signal, which comprises a first sinusoidal signal whose magnitude is less than a masking value, according to a psychoacoustic model in order to determine a second sinusoidal signal from among sinusoidal signals of a previous frame preceding a current frame which comprises the first sinusoidal signal, and a third sinusoidal signal from among sinusoidal signals of a next frame following the current frame, wherein the second sinusoidal signal and the third sinusoidal signal are connected to the first sinusoidal signal; encoding the first sinusoidal signal using a particular code indicating that a magnitude of the first sinusoidal signal is less than the masking value according to the psychoacoustic model; and encoding the third sinusoidal signal by performing difference coding for the third sinusoidal signal using only the second sinusoidal signal or both the first sinusoidal signal and the second sinusoidal signal, according to the particular code.

2. The method of claim 1, wherein the encoding the first sinusoidal signal using the particular code comprises designating one of control flags used to encode the first sinusoidal signal as a flag indicating that the magnitude of the first sinusoidal signal to be encoded is less than the masking value according to the psychoacoustic model.

3. The method of claim 1, wherein the encoding the first sinusoidal signal using the particular code comprises: encoding a particular value indicating that the magnitude of the first sinusoidal signal to be encoded is less than the masking value according to the psychoacoustic model, instead of encoding an amplitude component of the first sinusoidal signal; obtaining and encoding a difference between a frequency component of the first sinusoidal signal and a frequency component of the second sinusoidal signal; and obtaining and encoding a difference between a phase component of the first sinusoidal signal and a phase component of the second sinusoidal signal.

4. The method of claim 1, wherein the encoding the first sinusoidal signal using the particular code comprises encoding a particular value indicating that the magnitude of the first sinusoidal signal to be encoded is less than the masking value according to the psychoacoustic model, instead of encoding a frequency component or a phase component of the first sinusoidal signal.

5. The method of claim 1, further comprising, prior to the encoding the first sinusoidal signal using the particular code, converting a frequency component of the first sinusoidal signal into an average frequency value (fp+fn)/2 of a frequency component fp of the second sinusoidal signal and a frequency component fn of the third sinusoidal signal.

6. The method of claim 1, wherein the encoding the third sinusoidal signal comprises:
obtaining and encoding a difference between an amplitude component of the third sinusoidal signal and an amplitude component of the second sinusoidal signal;
obtaining and encoding a difference between a frequency component of the third sinusoidal signal and a frequency component of the second sinusoidal signal; and
obtaining and encoding a difference between a phase component of the third sinusoidal signal and a phase component of the second sinusoidal signal.

7. The method of claim 1, wherein the encoding of the third sinusoidal signal comprises: obtaining and encoding a difference between an amplitude component of the third sinusoidal signal and an amplitude component of the second sinusoidal signal; obtaining and encoding a difference between a frequency component of the third sinusoidal signal and a frequency component of the first sinusoidal signal; and obtaining and encoding a difference between a phase component of the third sinusoidal signal and a phase component of the first sinusoidal signal.

8. An apparatus for encoding a sinusoidal signal, the apparatus comprising: a sinusoidal tracking unit which is configured to perform sinusoidal tracking for an audio signal, which comprises a first sinusoidal signal whose magnitude is less than a masking value, according to a psychoacoustic model in order to determine a second sinusoidal signal from among sinusoidal signals of a previous frame preceding a current frame which comprises the first sinusoidal signal, and a third sinusoidal signal from among sinusoidal signals of a next frame following the current frame, wherein the second sinusoidal signal and the third sinusoidal signal are connected to the first sinusoidal signal; a first encoding unit which is configured to encode the first sinusoidal signal using a particular code indicating that a magnitude of the first sinusoidal signal is less than the masking value according to the psychoacoustic model; and a second encoding unit which is configured to encode the third sinusoidal signal by performing difference coding for the third sinusoidal signal using only the second sinusoidal signal or both the first sinusoidal signal and the second sinusoidal signal, according to the particular code.

9. A computer-readable recording medium having recorded thereon a program for executing the method of encoding a sinusoidal signal according to claim 1.

10. A method of decoding a sinusoidal signal, the method comprising: extracting from an input bitstream a particular code indicating that a magnitude of a first sinusoidal signal is less than a masking value according to a psychoacoustic model, wherein the first sinusoidal signal is connected to a third sinusoidal signal to be decoded among sinusoidal signals of a next frame following a current frame which comprises the first sinusoidal signal; and decoding the third sinusoidal signal by performing difference decoding for the third sinusoidal signal using only a second sinusoidal signal or both the first sinusoidal signal and the second sinusoidal signal according to a type of the particular code, wherein the second sinusoidal signal is connected to the first sinusoidal signal from among sinusoidal signals of a previous frame preceding the current frame.

11. The decoding method of claim 10, wherein the decoding the third sinusoidal signal according to the type of the particular code comprises, if a flag indicating that the magnitude of the first sinusoidal signal is less than the masking value according to the psychoacoustic model has been designated from among control flags used to encode the first sinusoidal signal or a particular value indicating that the magnitude of the first sinusoidal signal is less than the masking value according to the psychoacoustic model has been encoded instead of a frequency component or a phase component of the first sinusoidal signal, and the flag or the encoded particular value has been included in the input bitstream, obtaining an amplitude component of the third sinusoidal signal by extracting an encoded difference for an amplitude component of the third sinusoidal signal from the input bitstream, decoding the extracted difference for the amplitude component of the third sinusoidal signal, adding the decoded difference for the amplitude component of the third sinusoidal signal to an amplitude component of the second sinusoidal signal; obtaining a frequency component of the third sinusoidal signal by extracting an encoded difference for a frequency component of the third sinusoidal signal from the input bitstream, decoding the extracted difference for the frequency component of the third sinusoidal signal, adding the decoded difference for the frequency component of the third sinusoidal signal to a frequency component of the second sinusoidal signal; and obtaining a phase component of the third sinusoidal signal by extracting an encoded difference for a phase component of the third sinusoidal signal from the input bitstream, decoding the extracted difference for the phase component of the third sinusoidal signal, adding the decoded difference for the amplitude component of the third sinusoidal signal to a phase component of the second sinusoidal signal.

12. The decoding method of claim 10, wherein the decoding the third sinusoidal signal according to the type of the particular code comprises, if a particular value indicating that the magnitude of the first sinusoidal signal is less than the masking value according to the psychoacoustic model has been encoded instead of an amplitude component of the first sinusoidal signal and has been included in the input bitstream, obtaining an amplitude component of the third sinusoidal signal by extracting an encoded difference for the amplitude component of the third sinusoidal signal from the input bitstream, decoding the extracted difference for the amplitude component of the third sinusoidal signal, adding the decoded difference for the amplitude component of the third sinusoidal signal to an amplitude component of the second sinusoidal signal; obtaining a frequency component of the third sinusoidal signal by extracting an encoded difference for the frequency component of the third sinusoidal signal from the input bitstream, decoding the extracted difference for the frequency component of the third sinusoidal signal, adding the decoded difference for the frequency component of the third sinusoidal signal to a frequency component of the first sinusoidal signal; and obtaining a phase component of the third sinusoidal signal by extracting an encoded difference for the phase component of the third sinusoidal signal from the input bitstream, decoding the extracted difference for the phase component of the third sinusoidal signal, adding the decoded difference for the phase component of the third sinusoidal signal to a phase component of the first sinusoidal signal.

13. The decoding method of claim 10, further comprising: designating a value that is less than the masking value according to the psychoacoustic model as an amplitude component of the first sinusoidal signal; and designating an average frequency value (fp+fn)/2 of a frequency component fp of the second sinusoidal signal and a frequency component fn of the third sinusoidal signal as a frequency component of the first sinusoidal signal.

14. An apparatus for decoding a sinusoidal signal, the apparatus comprising: a code extraction unit which is configured to extract from an input bitstream a particular code indicating that a magnitude of a first sinusoidal signal is less than a masking value according to a psychoacoustic model, wherein the first sinusoidal signal is connected to a third sinusoidal signal to be decoded, among sinusoidal signals of a next frame following a current frame which comprises the first sinusoidal signal,; and a sinusoidal signal decoding unit which is configured to decode the third sinusoidal signal by performing difference decoding for the third sinusoidal signal using only a second sinusoidal signal or both the first sinusoidal signal and the second sinusoidal signal according to a type of the particular code, wherein the second sinusoidal signal is connected to the first sinusoidal signal from among sinusoidal signals of a previous frame preceding the current frame.

15. A computer-readable recording medium having recorded thereon a program for executing the method of decoding a sinusoidal signal according to claim 10.

## Patentansprüche

1. Verfahren zu m Codieren eines sinusförmigen Signals, mit den folgenden Schritten: Durchführen von sinusförmiger Verfolgung für ein Audiosignal, das ein erstes sinusförmiges Signal umfasst, dessen Betrag kleiner als ei n Maskierungswert ist, gemäß einem psychoakustischen Modell, um ein zweites sinusförmiges Signal unter sinusförmigen Signalen eines vorherigen Rahmens, der einem aktuellen Rahmen vorausgeht, der das erste sinusförmige Signal umfasst, und ein drittes sinusförmiges Signal unter sinusförmigen Signalen eines nächsten Rahmens, der dem aktuellen Rahmen folgt, zu bestimmen, wobei das zweite sinusförmige Signal und das dritte sinusförmige Signal mit dem ersten sinusförmigen Signal verbunden sind; Codieren de s ersten sinusförmigen Signals unter Verwendung eines bestimmten Codes, wodurch angegeben wird, dass ein Betrag des ersten sinusförmigen Signals kleiner als der Maskierungswert gemäß dem psychoakustischen Modell ist; und Codieren des dritten sinusförmigen Signals durch Durchführen von Differenzcodierung für das dritte sinusförmige Signal unter Verwendung nur des zweiten sinusförmigen Signals oder sowohl de s ersten sinusförmigen Signals al s auch de s zweiten sinusförmigen Signals, gemäß dem bestimmten Code.

2. Verfahren nach Anspruch 1, wobei das Codieren des ersten sinusförmigen Signals unter Verwendung des bestimmten Codes Folgendes umfasst: Designieren eines von zum Codieren des ersten sinusförmigen Signals verwendeten Steuer-Flags als ein Flag, das angibt, dass der Betrag des zu codierenden ersten sinusförmigen Signals kleiner als der Maskierungswert gemäß dem psychoakustischen Modell ist.

3. Verfahren nach Anspruch 1, wobei das Codieren des ersten sinusförmigen Signals unter Verwendung des bestimmten Codes Folgendes umfasst: Codieren eines bestimmten Werts, wodurch angegeben wird, dass der Betrag des zu codierenden ersten sinusförmigen Signals kleiner als der Maskierungswert gemäß dem psychoakustischen Modell ist, anstelle des Codierens einer Amplitudenkomponente des ersten sinusförmigen Signals; Erhalten und Codieren einer Differenz zwischen einer Frequenzkomponente de s ersten sinusförmigen Signals und einer Frequenzkomponente de s zweiten sinusförmigen Signals; und Erhalten und Codieren einer Differenz zwischen einer Phasenkomponente des ersten sinusförmigen Signals und einer Phasenkomponente des zweiten sinusförmigen Signals.

4. Verfahren nach Anspruch 1, wobei das Codieren des ersten sinusförmigen Signals unter Verwendung des bestimmten Codes Folgendes umfasst: Codieren eines bestimmten Werts, wodurch angezeigt wird, dass der Betrag des zu codierenden ersten sinusförmigen Signals kleiner als der Maskierungswert gemäß dem psychoakustischen Modell ist, anstelle des Codierens einer Frequenzkomponente oder einer Phasenkomponente des ersten sinusförmigen Signals.

5. Verfahren nach Anspruch 1, das ferner vor dem Codieren des ersten sinusförmigen Signals unter Verwendung des bestimmten Codes Folgendes umfasst: Umsetzen einer Frequenzkomponente des ersten sinusförmigen Signals in einen mittleren Frequenzwert (fp+fn)/2 einer Frequenzkomponente fp de s zweiten sinusförmigen Signals und einer Frequenzkomponente fn des dritten sinusförmigen Signals.

6. Verfahren nach Anspruch 1, wobei das Codieren des dritten sinusförmigen Signals Folgendes umfasst: Erhalten und Codieren einer Differenz zwischen einer Amplitudenkomponente des dritten sinusförmigen Signals und einer Amplitudenkomponente des zweiten sinusförmigen Signals; Erhalten und Codieren einer Differenz zwischen einer Frequenzkomponente d e s dritten sinusförmigen Signals und einer Frequenzkomponente des zweiten sinusförmigen Signals; und Erhalten und Codieren einer Differenz zwischen einer Phasenkomponente des dritten sinusförmigen Signals und einer Phasenkomponente des zweiten sinusförmigen Signals.

7. Verfahren nach Anspruch 1, wobei das Codieren des dritten sinusförmigen Signals Folgendes umfasst: Erhalten und Codieren einer Differenz zwischen einer Amplitudenkomponente des dritten sinusförmigen Signals und einer Amplitudenkomponente des zweiten sinusförmigen Signals; Erhalten und Codieren einer Differenz zwischen einer Frequenzkomponente de s dritten sinusförmigen Signals und einer Frequenzkomponente des ersten sinusförmigen Signals; und Erhalten und Codieren einer Differenz zwischen einer Phasenkomponente des dritten sinusförmigen Signals un d einer Phasenkomponente des ersten sinusförmigen Signals.

8. Vorrichtung zum Codieren eines sinusförmigen Signals, wobei die Vorrichtung Folgendes umfasst: eine Einheit zur sinusförmigen Verfolgung , die dafür ausgelegt ist, sinusförmige Verfolgung für ein Audiosignal durchzuführen, das ein erstes sinusförmiges Signal umfasst, dessen Betrag kleiner als ein Maskierungswert ist, gemäß einem psychoakustischen Modell, um ein zweites sinusförmiges Signal unter sinusförmigen Signalen eines vorherigen Rahmens, der einem aktuellen Rahmen vorausgeht, der das erste sinusförmige Signal umfasst, un d ei n drittes sinusförmiges Signal unter sinusförmigen Signalen eines nächsten Rahmens, der dem aktuellen Rahmen folgt, zu bestimmen, wobei das zweite sinusförmige und das dritte sinusförmige Signal mit dem ersten sinusförmigen Signal verbunden sind; eine erste Codierungseinheit, die dafür ausgelegt ist, das erste sinusförmige Signal unter Verwendung eines bestimmten Codes zu codieren, wodurch angezeigt wird, dass ein Betrag de s ersten sinusförmigen Signals kleiner als der Maskierungswert gemäß dem psychoakustischen Modell ist; und eine zweite Codierungseinheit, die dafür ausgelegt ist, das dritte sinusförmige Signal durch Durchführen von Differenzcodierung für das dritte sinusförmige Signal unter Verwendung nur des zweiten sinusförmigen Signals oder sowohl des ersten sinusförmigen Signals als auch des zweiten sinusförmigen Signals gemäß dem bestimmten Code zu codieren.

9. Computerlesbares Aufzeichnungsmedium, auf dem ein Programm zum Ausführen des Verfahrens zum Codieren eines sinusförmigen Signals nach Anspruch 1 aufgezeichnet ist.

10. Verfahren zum Decodieren eines sinusförmigen Signals, mit den folgenden Schritten: Extrahieren eines bestimmten Codes aus einem Eingangsbitstrom, wodurch angezeigt wird, dass ein Betrag eines ersten sinusförmigen Signals kleiner als ein Maskierungswert gemäß einem psychoakustischen Modell ist, wobei das erste sinusförmige Signal mit einem zu decodierenden dritten sinusförmigen Signal unter sinusförmigen Signalen eines nächsten Rahmens, der einem aktuellen Rahmen folgt, de r das erste sinusförmige Signal umfasst, verbunden ist; und Decodieren des dritten sinusförmigen Signals durch Durchführen von Differenzdecodierung für das dritte sinusförmige Signal unter Verwendung nur eines zweiten sinusförmigen Signals oder sowohl des ersten sinusförmigen Signals als auch des zweiten sinusförmigen Signals gemäß einem Typ des bestimmten Codes, wobei das zweite sinusförmige Signal mit dem ersten sinusförmigen Signal unter sinusförmigen Signalen eines vorherigen Rahmens, der dem aktuellen Rahmen vorausgeht, verbunden ist.

11. Decodierungsverfahren nach Anspruch 10, wobei das Decodieren des dritten sinusförmigen Signals gemäß dem Typ des bestimmten Codes Folgendes umfasst: wenn ein Flag, das angibt, dass der Betrag des ersten sinusförmigen Signals kleiner als die Maskierungsschwelle gemäß dem psychoakustischen Modell ist, unter zum Codieren des ersten sinusförmigen Signals verwendeten Steuer-Flags designiert wurde oder ein bestimmter Wert, der angibt, dass der Betrag des ersten sinusförmigen Signals kleiner als der Maskierungswert gemäß dem psychoakustischen Modell ist, anstelle einer Frequenzkomponente oder einer Phasenkomponente des ersten sinusförmigen Signals codiert wurde und das Flag oder der codierte bestimmte Wert in den Eingangsbitstrom aufgenommen wurde, Erhalten einer Amplitudenkomponente des dritten sinusförmigen Signals durch Extrahieren einer codierten Differenz für eine Amplitudenkomponente des dritten sinusförmigen Signals aus dem Eingangsbitstrom, Decodieren der extrahierten Differenz für die Amplitudenkomponente des dritten sinusförmigen Signals, Addieren der decodierten Differenz für die Amplitudenkomponente des dritten sinusförmigen Signals zu einer Amplitudenkomponente des zweiten sinusförmigen Signals; Erhalten einer Frequenzkomponente des dritten sinusförmigen Signals durch Extrahieren einer codierten Differenz für eine Frequenzkomponente des dritten sinusförmigen Signals aus dem Eingangsbitstrom, Decodieren der extrahierten Differenz für die Frequenzkomponente des dritten sinusförmigen Signals, Addieren der decodierten Differenz für die Frequenzkomponente des dritten sinusförmigen Signals zu einer Frequenzkomponente des zweiten sinusförmigen Signals; und Erhalten einer Phasenkomponente des dritten sinusförmigen Signals durch Extrahieren einer codierten Differenz für eine Phasenkomponente des dritten sinusförmigen Signals aus dem Eingangsbitstrom, Decodieren der extrahierten Differenz für die Phasenkomponente des dritten sinusförmigen Signals, Addieren der decodierten Differenz für die Amplitudenkomponente des dritten sinusförmigen Signals zu einer Phasenkomponente des zweiten sinusförmigen Signals.

12. Decodierungsverfahren nach Anspruch 10, wobei das Decodieren des dritten sinusförmigen Signals gemäß dem Typ des bestimmten Codes Folgendes umfasst: wenn ein bestimmter Wert, der angibt, dass der Betrag des ersten sinusförmigen Signals kleiner als der Maskierungswert gemäß dem psychoakustischen Modell ist, anstelle einer Amplitudenkomponente des ersten sinusförmigen Signals codiert wurde und in den Eingangsbitstrom aufgenommen wurde, Erhalten einer Amplitudenkomponente des dritten sinusförmigen Signals durch Extrahieren einer codierten Differenz für die Amplitudenkomponente des dritten sinusförmigen Signals aus dem Eingangsbitstrom, Decodieren der extrahierten Differenz für die Amplitudenkomponente des dritten sinusförmigen Signals, Addieren der decodierten Differenz für die Amplitudenkomponente des dritten sinusförmigen Signals zu einer Amplitudenkomponente des zweiten sinusförmigen Signals; Erhalten einer Frequenzkomponente des dritten sinusförmigen Signals durch Extrahieren einer codierten Differenz für die Frequenzkomponente des dritten sinusförmigen Signals aus de m Eingangsbitstrom, Decodieren der extrahierten Differenz für die Frequenzkomponente des dritten sinusförmigen Signals, Addieren der decodierten Differenz für die Frequenzkomponente des dritten sinusförmigen Signals zu einer Frequenzkomponente des ersten sinusförmigen Signals; und Erhalten einer Phasenkomponente des dritten sinusförmigen Signals durch Extrahieren einer codierten Differenz für die Phasenkomponente des dritten sinusförmigen Signals aus dem Eingangsbitstrom, Decodieren der extrahierten Differenz für die Phasenkomponente des dritten sinusförmigen Signals, Addieren der decodierten Differenz für die Phasenkomponente des dritten sinusförmigen Signals zu einer Phasenkomponente des ersten sinusförmigen Signals.

13. Decodierungsverfahren nach Anspruch 10, ferner mit den folgenden Schritten: Designieren eines Werts, der kleiner als der Maskierungswert gemäß dem psychoakustischen Modell ist, als eine Amplitudenkomponente des ersten sinusförmigen Signals; und Designieren eines mittleren Frequenzwerts (fp+fn)/2 einer Frequenzkomponente fp des zweiten sinusförmigen Signals und einer Frequenzkomponente fn des dritten sinusförmigen Signals als eine Frequenzkomponente des ersten sinusförmigen Signals.

14. Vorrichtung zum Decodieren eines sinusförmigen Signals, wobei die Vorrichtung Folgendes umfasst: eine Codeextraktionseinheit, die dafür ausgelegt ist, aus einem Eingangsbitstrom einen bestimmten Code zu extrahieren, wodurch angezeigt wird, dass ein Betrag eines ersten sinusförmigen Signals kleiner als ein Maskierungswert gemäß einem psychoakustischen Modell ist, wobei das erste sinusförmige Signal mit einem zu decodierenden dritten sinusförmigen Signal verbunden ist, unter sinusförmigen Signalen eines nächsten Rahmens, der einem aktuellen Rahmen folgt, der das erste sinusförmige Signal umfasst; un d eine Decodierungseinheit für sinusförmige Signale, die dafür ausgelegt ist, das dritte sinusförmige Signal durch Durchführen Von Differenzdecodierung für das dritte sinusförmige Signal unter Verwendung nur eines zweiten sinusförmigen Signals oder sowohl des ersten sinusförmigen Signals als auch des zweiten sinusförmigen Signals gemäß einem Typ des bestimmten Codes zu decodieren, wobei das zweite sinusförmige Signal mit dem ersten sinusförmigen Signal unter sinusförmigen Signalen eines vorherigen Rahmens, der dem aktuellen Rahmen vorausgeht, verbunden ist.

15. Computerlesbares Aufzeichnungsmedium, auf dem ein Programm zum Ausführen des Verfahrens zum Decodieren eines sinusförmigen Signals nach Anspruch 10 aufgezeichnet ist.

## Revendications

1. Procédé de codage d'un signal sinusoïdal, le procédé comprenant : l'exécution d'une poursuite sinusoïdale d'un signal audio comprenant un premier signal sinusoïdal dont le niveau est inférieur à une valeur de masquage conformément à un modèle psychoacoustique afin de déterminer un deuxième signal sinusoïdal parmi des signaux sinusoïdaux d'une trame précédente qui précède une trame courante comprenant le premier signal sinusoïdal, et un troisième signal sinusoïdal parmi des signaux sinusoïdaux d'une trame suivante faisant suite à la trame courante, dans lequel le deuxième signal sinusoïdal et le troisième signal sinusoïdal sont connectés au premier signal sinusoïdal ; le codage du premier signal sinusoïdal en utilisant un code particulier indiquant qu'un niveau du premier signal sinusoïdal est inférieur à la valeur de masquage conformément au modèle psychoacoustique ; et le codage du troisième signal sinusoïdal en effectuant un codage de différence pour le troisième signal sinusoïdal en n'utilisant que le deuxième signal sinusoïdal ou à la fois le premier signal sinusoïdal et le deuxième signal sinusoïdal, conformément au code particulier.

2. Procédé selon la revendication 1, dans lequel le codage du premier signal sinusoïdal en utilisant le code particulier comprend la désignation de l'un d'indicateurs de commande utilisés pour code r le premier signal sinusoïdal en tant qu'indicateur indiquant que le niveau du premier signal sinusoïdal à coder es t inférieur à la valeur de masquage conformément au modèle psychoacoustique.

3. Procédé selon la revendication 1, dans lequel le codage du premier signal sinusoïdal en utilisant le code particulier comprend : le codage d'une valeur particulière indiquant que le niveau du premier signal sinusoïdal à coder est inférieur à la valeur de masquage conformément au modèle psychoacoustique, au lieu de coder une composante d'amplitude du premier signal sinusoïdal ; l'obtention et le codage d'une différence entre une composante de fréquence du premier signal sinusoïdal et une composante de fréquence du deuxième signal sinusoïdal ; et l'obtention et le codage d'une différence entre une composante de phase du premier signal sinusoïdal et une composante de phase du deuxième signal sinusoïdal.

4. Procédé selon la revendication 1, dans lequel le codage du premier signal sinusoïdal en utilisant le code particulier comprend le codage d'une valeur particulière indiquant que le niveau du premier signal sinusoïdal à coder est inférieur à la valeur de masquage conformément au modèle psychoacoustique, au lieu du codage d'une composante de fréquence ou d'une composante de phase du premier signal sinusoïdal.

5. Procédé selon la revendication 1, comprenant en outre, avant le codage du premier signal sinusoïdal en utilisant le code particulier, la conversion d'une composante de fréquence du premier signal sinusoïdal en une valeur de fréquence moyenne (fp+fn)/2 d'une composante de fréquence fp du deuxième signal sinusoïdal et d'une composante de fréquence fn du troisième signal sinusoïdal.

6. Procédé selon la revendication 1, dans lequel le codage du troisième signal sinusoïdal comprend :
l'obtention et le codage d'une différence entre une composante d'amplitude du troisième signal sinusoïdal et une composante d'amplitude du deuxième signal sinusoïdal ; l'obtention et le codage d'une différence entre une composante de fréquence du troisième signal sinusoïdal et une composante de fréquence du deuxième signal sinusoïdal ; et l'obtention et le codage d'une différence entre une composante de phase du troisième signal sinusoïdal et une composante de phase du deuxième signal sinusoïdal.

7. Procédé selon la revendication 1, dans lequel le codage du troisième signal sinusoïdal comprend :
l'obtention et le codage d'une différence entre une composante d'amplitude du troisième signal sinusoïdal et une composante d'amplitude du deuxième signal sinusoïdal ; l'obtention et le codage d'une différence entre une composante de fréquence du troisième signal sinusoïdal et une composante de fréquence du premier signal sinusoïdal ; et l'obtention et le codage d'une différence entre une composante de phase du troisième signal sinusoïdal et une composante de phase du premier signal sinusoïdal.

8. Appareil destiné à coder un signal sinusoïdal, l'appareil comprenant : une unité de poursuite sinusoïdale qui est configurée pour effectuer une poursuite sinusoïdale d'un signal audio comprenant un premier signal sinusoïdal dont le niveau est inférieur à une valeur de masquage, conformément à un modèle psychoacoustique afin de déterminer un deuxième signal sinusoïdal parmi des signaux sinusoïdaux d'une trame précédente qui précède une trame courante comprenant le premier signal sinusoïdal, et un troisième signal sinusoïdal parmi des signaux sinusoïdaux d'une trame suivante faisant suite à la trame courante, le deuxième signal sinusoïdal et le troisième signal sinusoïdal étant connectés au premier signal sinusoïdal ; une première unité de codage qui est configurée pour coder le premier signal sinusoïdal en utilisant un code particulier indiquant qu'un niveau du premier signal sinusoïdal est inférieur à la valeur de masquage conformément au modèle psychoacoustique ; et une deuxième unité de codage qui est configurée pour coder le troisième signal sinusoïdal en effectuant un codage de différence pour le troisième signal sinusoïdal en n'utilisant que le deuxième signal sinusoïdal ou à la fois le premier signal sinusoïdal et le deuxième signal sinusoïdal, conformément au code particulier.

9. Support d'enregistrement lisible par ordinateur sur lequel est enregistré un programme destiné à exécuter le procédé de codage d'un signal sinusoïdal selon la revendication 1.

10. Procédé de décodage d'un signal sinusoïdal, le procédé comprenant : l'extraction, d'un flux binaire d'entrée, d'un code particulier indiquant qu'un niveau d'un premier signal sinusoïdal est inférieur à une valeur de masquage conformément à un modèle psychoacoustique, le premier signal sinusoïdal étant connecté à un troisième signal sinusoïdal devant être décodé parmi de s signaux sinusoïdaux d' une trame suivante faisant suite à une trame courante comprenant le premier signal sinusoïdal ; et le décodage du troisième signal sinusoïdal en effectuant un décodage de différence pour le troisième signal sinusoïdal en n'utilisant qu'un deuxième signal sinusoïdal ou à la fois le premier signal sinusoïdal et le deuxième signal sinusoïdal conformément à un type du code particulier, le deuxième signal sinusoïdal étant connecté au premier signal sinusoïdal parmi des signaux sinusoïdaux d'une trame précédente qui précède la trame courante.

11. Procédé de décodage selon la revendication 10, dans lequel le décodage du troisième signal sinusoïdal conformément au type du code particulier comprend, si un indicateur indiquant que le niveau du premier signal sinusoïdal est inférieur à la valeur de masquage conformément au modèle psychoacoustique a été désigné parmi des indicateurs de commande utilisés pour coder le premier signal sinusoïdal ou si une valeur particulière indiquant que le niveau du premier signal sinusoïdal est inférieur à la valeur de masquage conformément au modèle psychoacoustique a été codée au lieu d'une composante de fréquence ou d'une composante de phase du premier signal sinusoïdal, et si l'indicateur ou la valeur particulière codée a été inclus dans le flux binaire d'entrée, l'obtention d'une composante d'amplitude du troisième signal sinusoïdal en extrayant une différence codée, pour une composante d'amplitude du troisième signal sinusoïdal, du flux binaire d'entrée, le décodage de la différence extraite pour la composante d'amplitude du troisième signal sinusoïdal, l'ajout de la différence décodée pour la composante d'amplitude du troisième signal sinusoïdal à une composante d'amplitude du deuxième signal sinusoïdal ; l'obtention d'une composante de fréquence du troisième signal sinusoïdal en extrayant une différence codée, pour une composante de fréquence du troisième signal sinusoïdal, du flux binaire d'entrée, le décodage de la différence extraite pour la composante de fréquence du troisième signal sinusoïdal, l'ajout de la différence décodée pour la composante de fréquence du troisième signal sinusoïdal à une composante de fréquence du deuxième signal sinusoïdal ; et l'obtention d'une composante de phase du troisième signal sinusoïdal en extrayant une différence codée, pour une composante de phase du troisième signal sinusoïdal, du flux binaire d'entrée, le décodage de la différence extraite pour la composante de phase du troisième signal sinusoïdal, l'ajout de la différence décodée pour la composante d'amplitude du troisième signal sinusoïdal à une composante de phase du deuxième signal sinusoïdal.

12. Procédé de décodage selon la revendication 10, dans lequel le décodage du troisième signal sinusoïdal conformément au type du code particulier comprend, si une valeur particulière indiquant que le niveau du premier signal sinusoïdal est inférieur à la valeur de masquage conformément au modèle psychoacoustique a été codée au lieu d'une composante d'amplitude du premier signal sinusoïdal et a été incluse dans le flux binaire d'entrée, l'obtention d'une composante d'amplitude du troisième signal sinusoïdal en extrayant une différence codée, pour la composante d'amplitude du troisième signal sinusoïdal, du flux binaire d'entrée, le décodage de la différence extraite pour la composante d'amplitude du troisième signal sinusoïdal, l'ajout de la différence décodée pour la composante d'amplitude du troisième signal sinusoïdal à un e composante d'amplitude du deuxième signal sinusoïdal ; l'obtention d'une composante de fréquence du troisième signal sinusoïdal en extrayant une différence codée, pour la composante de fréquence du troisième signal sinusoïdal, du flux binaire d'entrée, le décodage de la différence extraite pour la composante de fréquence du troisième signal sinusoïdal, l'ajout de la différence décodée pour la composante de fréquence du troisième signal sinusoïdal à une composante de fréquence du premier signal sinusoïdal ; et l'obtention d'une composante de phase du troisième signal sinusoïdal en extrayant une différence codée, pour la composante de phase du troisième signal sinusoïdal, du flux binaire d'entrée, le décodage de la différence extraite pour la composante de phase du troisième signal sinusoïdal, l'ajout de la différence décodée pour la composante de phase du troisième signal sinusoïdal à une composante de phase du premier signal sinusoïdal.

13. Procédé de décodage selon la revendication 10, comprenant en outre : la désignation d'une valeur qui est inférieure à la valeur de masquage conformément au modèle psychoacoustique en tant que composante d'amplitude du premier signal sinusoïdal ; et la désignation d'une valeur de fréquence moyenne (fp+fn)/2 d'une composante de fréquence fp du deuxième signal sinusoïdal et d'une composante de fréquence fn du troisième signal sinusoïdal en tant que composante de fréquence du premier signal sinusoïdal.

14. Appareil destiné à décoder un signal sinusoïdal, l' appareil comprenant : u n e unité d'extraction de code qui est configurée pour extraire d'un flux binaire d'entrée un code particulier indiquant qu'un niveau d'un premier signal sinusoïdal est inférieur à une valeur de masquage conformément à un modèle psychoacoustique, le premier signal sinusoïdal étant connecté à un troisième signal sinusoïdal à décoder, parmi des signaux sinusoïdaux d'une trame suivante faisant suite à une trame courante comprenant le premier signal sinusoïdal ; et une unité de décodage de signal sinusoïdal qui est configurée pour décoder le troisième signal sinusoïdal en effectuant un décodage de différence pour le troisième signal sinusoïdal en n'utilisant qu'un deuxième signal sinusoïdal ou à la fois le premier signal sinusoïdal et le deuxième signal sinusoïdal conformément à un type du code particulier, le deuxième signal sinusoïdal étant connecté au premier signal sinusoïdal parmi les signaux sinusoïdaux d'une trame précédente qui précède la trame courante.

15. Support d'enregistrement lisible par ordinateur sur lequel est enregistré un programme destiné à exécuter un procédé de décodage d'un signal sinusoïdal selon la revendication 10.
